# EUROPÄISCHE PATENTSCHRIFT

(11) **EP 1 907 870 B1**
(45) Veröffentlichungstag und Bekanntmachung des Hinweises auf die Patenterteilung: **21.02.2018**
(21) Anmeldenummer: 06754638.2
(22) Anmeldetag: 30.06.2006
(51) Int. Cl.: G01R 13/02, G01R 13/34, G01R 13/32

(54) **VERFAHREN UND SYSTEM ZUR DIGITALEN TRIGGERUNG VON SIGNALEN AUF DER BASIS VON ZWEI ZEITLICH BEABSTANDETEN TRIGGEREREIGNISSEN**
METHOD AND SYSTEM FOR DIGITALLY TRIGGERING SIGNALS ON THE BASE OF TWO TRIGGERING EVENTS SEPARATED BY A TIME INTERVAL
PROCEDE ET SYSTEME POUR LE DECLENCHEMENT NUMERIQUE DE SIGNAUX SUR LA BASE DE DEUX EVENEMENTS DE DECLENCHEMENT SEPARES PAR UN INTERVALLE DE TEMPS

(30) Priorität: 28.07.2005 DE 102005035394
(43) Veröffentlichungstag der Anmeldung: 09.04.2008
(73) Patentinhaber: Rohde & Schwarz GmbH & Co. KG, 81671 München (DE)
(72) Erfinder: FREIDHOF, Markus, 85614 Kirchseeon (DE); HUBER, Johann, 85570 Markt Schwaben (DE)
(74) Vertreter: Körfer, Thomas
(86) Internationale Anmeldenummer: PCT/EP2006/006368
(87) Internationale Veröffentlichungsnummer: WO 2007/012376

(56) Entgegenhaltungen:
- EP-A- 0 740 161
- DE-A1- 3 936 932
- US-A- 5 446 650
- US-A1- 2003 220 753
- US-B1- 6 753 677

## Beschreibung

Die Erfindung betrifft ein Verfahren und System zur digitalen Triggerung von Signalen auf der Basis von zwei zeitlich beabstandeten Triggerereignissen.

Digitale Oszilloskope können analoge Signale nach zeitlicher Abtastung des Analogsignals und Digitalisierung der Abtastwerte des Analogsignals zu den einzelnen Abtastzeitpunkten mittels Analog-Digital-Wandelung mit einer inzwischen sehr guten Genauigkeit auf einer Anzeigeeinrichtung darstellen.

Die Triggerung der auf der Anzeigeeinrichtung des Digitaloszilloskops darzustellenden digitalisierten Signale ist zwischenzeitlich auch digital realisiert. In der DE 39 36 932 A1 wird ein ins digitale Datenformat gewandelte Analogsignal mit einem in einem Register gespeicherten Schwellwert in einem Komparator auf Über- oder Unterschreitung verglichen. Die erstmalige Über- oder Unterschreitung des Schwellwertes durch einen der Abtastwerte des darzustellenden Analogsignals wird als Triggerzeitpunkt vom digitalen Triggersystem identifiziert und führt zu einem Triggerimpuls, der in der Anzeigeeinrichtung zur triggerimpulssynchronen Aufzeichnung der darzustellenden Signale dient.

Die digitale Triggerung der DE 39 36 932 A1 führt einzig eine statische Triggerung auf der Basis eines einmaligen Signalpegelvergleichs mit einem Schwellwert durch. Eine dynamische Triggerung auf der Basis eines zeitabhängigen Signalmerkmals - beispielsweise eine Triggerung auf der Basis einer Signalflanke eines Signals, einer Impulsdauer eines Signalimpulses oder einer zeitlichen Verzögerung eines Signalimpulses gegenüber einem Referenzimpuls - ist mit einem derartigen digitalen Triggersystem nachteilig noch nicht möglich. Die EP-A-0 740 161 (FLUKE CORPORATION, 30. Oktober 1996) zeigt ein Digitaloszilloskop mit auf Mustererkennung basierender Triggerung.

Der Erfindung liegt deshalb die Aufgabe zugrunde, ein Verfahren und ein System zur digitalen Triggerung von Signalen zu schaffen, in dem auch zeitabhängige Signalmerkmale des auf dem digitalen Oszilloskop darzustellenden Signals als Triggerbedingung für eine digitale Triggerung herangezogen werden können, sowie ein entsprechendes digitales Oszilloskop anzugehen.

Die Aufgabe der Erfindung wird durch ein Verfahren zur digitalen Triggerung nach Anspruch 1 und durch ein System zur digitalen Triggerung nach Anspruch 16 sowie ein digitales Osziloskop nach Anspruch 22 gelöst. Vorteilhafte Weiterbildungen der Erfindung sind in den abhängigen Ansprüchen aufgeführt.

Erfindungsgemäß werden in einer derartigen digitalen Triggerung anstelle eines Triggerereignisses auf der Basis eines Pegelvergleichs mit einem Schwellwert gemäß dem Stand der Technik zwei Triggerereignisse auf der Basis zweier Pegelvergleiche mit jeweils einem Schwellwert identifiziert und der Zeitabstand zwischen beiden Triggerereignissen als Triggerbedingung für eine dynamische Triggerung benutzt. Die erfindungsgemäße digitale Triggerung erfolgt sowohl bei Über- als auch Unterschreitung eines Schwellwertes durch den Zeitabstand zwischen den beiden identifizierten Triggerereignissen. Auf diese Weise ist eine digitale Triggerung alternativ bei positiver oder negativer Signalflanke, bei einem Signalimpuls bis zu einer Maximalimpulsdauer oder ab einer Minimalimpulsdauer oder bei einer Signalimpulsverzögerung bis zu einer Maximalimpulsverzögerung oder ab einer Minimalimpulsverzögerung möglich.

Der Zeitabstand zwischen dem ersten und zweiten Triggerereignis wird über die Anzahl von Abtastzeitpunkten der zu triggernden Signale zwischen den beiden Triggerereignissen ermittelt. Aufgrund der Zeitdiskretisierung entsteht einerseits eine erste Ungenauigkeit in der präzisen Bestimmung des ersten und zweiten Triggerereignisses als Zeitpunkt der exakten Über- oder Unterschreitung des Schwellwertes durch das für die Triggerung jeweils benutzte zeitdiskretisierte Signal - Referenzsignal - und andererseits eine zweite Ungenauigkeit aufgrund eines möglichen Synchronitätsfehlers zwischen dem jeweils ermittelten ersten oder zweiten Triggerereignis und dem Abtastungsraster der auf dem Digitaloszilloskop darzustellenden Signale.

Die erste Ungenauigkeit aufgrund der nicht präzisen Bestimmung des ersten und zweiten Triggerereignisses wird durch Bestimmung der Pegel von Zwischenpunkten zwischen dem letzt vorausgehenden Abtastzeitpunkt und dem nächst folgenden Abtastzeitpunkt des/der Referenzsignale/e vor bzw. nach dem ersten bzw. zweiten Triggerereignis mittels Interpolation und Vergleich der ermittelten Pegel der Zwischenpunkte mit dem/den Schwellwert/en auf Über- oder Unterschreitung gelöst. Auf diese Weise können die Zeitpunkte des ersten und zweiten Triggerereignisses deutlich präziser bestimmt werden.

Die zweite Ungenauigkeit aufgrund des Synchronitätsfehlers führt dazu, dass das Eintreten der Triggerbedingung entweder eindeutig identifiziert oder eindeutig nicht identifiziert oder weder eindeutig identifiziert noch eindeutig nicht identifiziert werden kann. Die Triggerbedingung wird eindeutig identifiziert oder eindeutig nicht identifiziert, falls die ermittelte Anzahl von Abtastzeitpunkten zwischen ersten und zweiten Triggerereignis entweder einen oberen Grenzwert überschreitet oder einen unteren Grenzwert unterschreitet. Liegt die ermittelte Anzahl von Abtastzeitpunkten zwischen dem ersten und zweiten Triggerereignis zwischen diesem oberen und unteren Grenzwert, so kann das Eintreten der Triggerbedingung weder eindeutig identifiziert noch eindeutig nicht identifiziert werden. In diesem Fall kann die Anzeige der auf dem digitalen Oszilloskop darzustellenden Signale über einen Triggerimpuls nicht gestartet werden und muß bis zu einer eindeutigen Identifizierung der Triggerbedingnug verschoben werden.

In diesem Fall müssen die einzelnen Abtastwerte der auf dem digitalen Oszilloskop darzustellenden Signale in einem FIFO-Speicher zwischengespeichert werden und in einer weiteren nachträglichen Ermittlung der präzisen Zeitpunkte der ersten und zweiten Triggerereignisse und damit des präzisen Zeitabstands zwischen ersten und zweiten Triggerereignis das eindeutige Eintreten oder das eindeutige Nicht-Eintreten der Triggerbedingung ermittelt werden. Wird das Vorliegen der Triggerbedingung in der Feinanalyse identifiziert, so werden die im FIFO-Speicher zwischengespeicherten Abtastwerte der aufzuzeichnenden Signale über einen Triggerimpuls auf der Anzeige des digitalen Oszilloskops nachträglich dargestellt.

Ergänzend sei erwähnt, daß die oberen und unteren Grenzwerte für die Anzahl von Abtastzeitpunkten zwischen ersten und zweiten Triggerereignis zur eindeutigen Identifizierung oder eindeutigen Nichtidentifizierung der Triggerbedingung für den Fall der Überschreitung eines Schwellwertes einen anderen Wert - erster unterer und erster oberer Grenzwert - als für den Fall der Unterschreitung eines Schwellwertes - zweiter unterer und zweiter oberer Grenzwert - annimmt. Zusätzlich weist der obere und untere Grenzwert für einen Schwellwertvergleich des Zeitabstandes zwischen dem ersten und zweiten Triggerzeitpunkt mit ">="- bzw. "<="-Ungleichungsbedingung andere Werte als für einen Schwellwertvergleich des Zeitabstands zwischen dem ersten und zweiten Triggerzeitpunkt mit ">"- bzw. "<"-Ungleichungsbedingung auf.

Die beispielhafte Ausführungsform des erfindungsgemäßen Verfahrens und Systems zur digitalen Triggerung von Signalen auf der Basis von zwei zeitlich beabstandeten Triggerereignissen und das erfindungsgemäße digitale Oszilloskop werden im folgenden unter Berücksichtigung der Zeichnung näher erläutert. In der Zeichnung zeigen:
- Fig.1: ein Blockschaltbild eines digitalen Oszilloskops nach dem Stand der Technik,
- Fig. 2: ein Blockschaltbild eines erfindungsgemäßen Systems zur digitalen Triggerung von Signalen auf der Basis von zwei zeitlich beabstandeten Triggerereignissen,
- Fig. 3: ein Blockschaltbild eines erfindungsgemäßen Sub-Systems zur Feinanalyse von Triggerbedingungen,
- Fig. 4: ein Blockschaltbild eines erfindungsgemäßen digitalen Oszilloskops,
- Fig. 5A, 5B, 5C, 5D, 5E, 5F: Zeitverläufe verschiedener Triggerbedingungen,
- Fig. 6: ein Flußdiagramm eines erfindungsgemäßen Verfahrens zur digitalen Triggerung von Signalen auf der Basis von zwei zeitlich beabstandeten Triggerereignissen und
- Fig. 7: ein Flußdiagramm eines erfindungsgemäßen Unterverfahrens zur Feinanalyse von Triggerbedingungen.

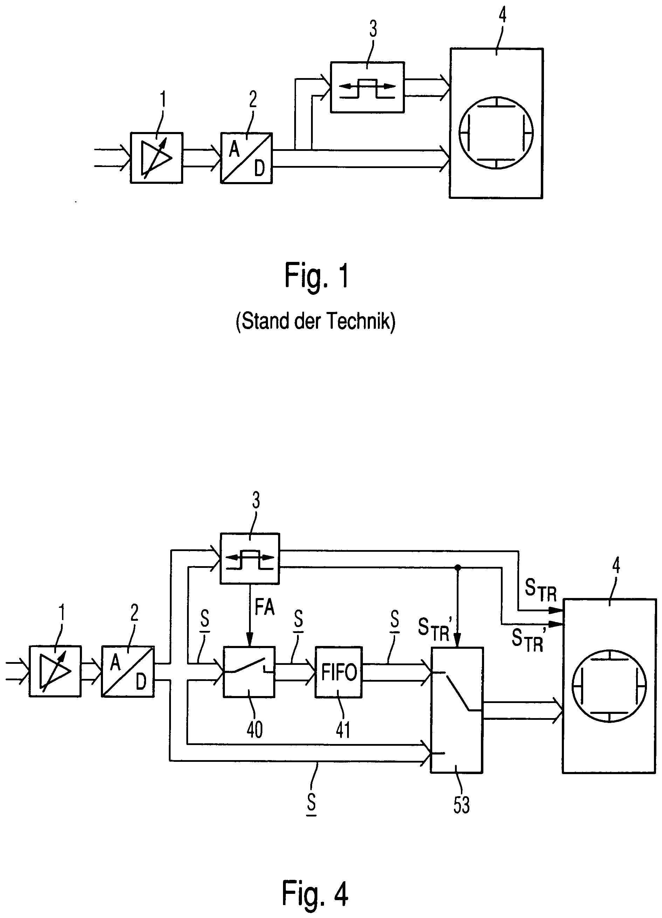

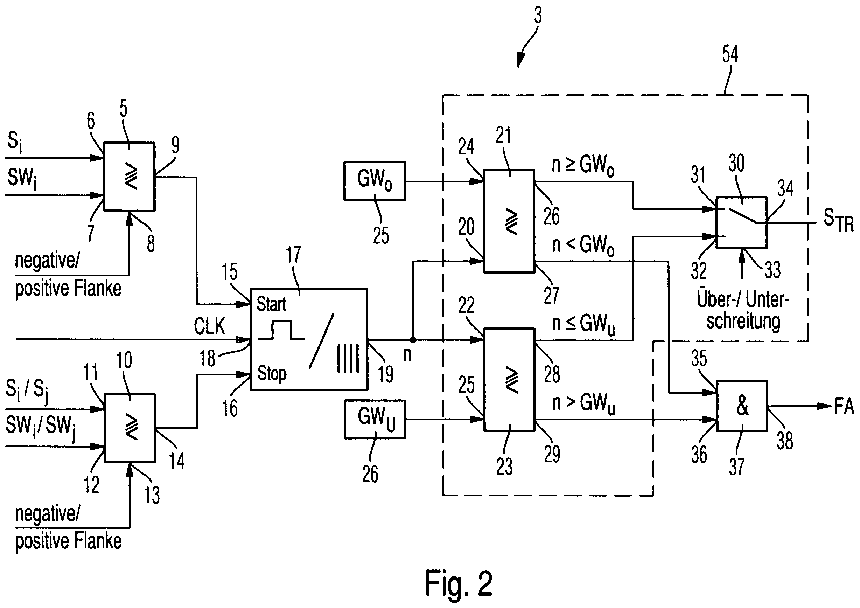

Bevor anhand der Figuren 2 bis 7 das erfindungsgemäße Verfahren und System zur digitalen Triggerung von Signalen auf der Basis von zwei zeitlich beabstandeten Triggerereignissen und das dazugehörige erfindungsgemäße digitale Oszilloskop beschrieben wird, wird im folgenden anhand von Fig. 1 das digitale Oszilloskop nach dem Stand der Technik vorgestellt, das für das weitere Verständnis der Erfindung erforderlich ist.

Das digitale Oszilloskop nach dem Stand der Technik in Fig. 1 führt mit einem Vorverstärker 1, der einen veränderlichen Verstärkungsfaktor aufweist, eine Pegelanpassung der Amplituden der an seinem Eingang anliegenden Meßsignale an den Messbereich der Anzeigeeinrichtung 4 durch. Nach der Pegelanpassung werden die vorverstärkten analogen Meßsignale einem Analog-Digital-Wandler 2 zur Wandlung in ein korrespondierendes digitales Datenformat zugeführt. Das digitalisierte Meßsignal wird von einem erfindungsgemäßen digitalen Triggersystem 3 hinsichtlich einer Triggerbedingung geprüft. Bei Identifizierung dieser Triggerbedingung wird am Ausgang des digitalen Triggersystems 3 ein Triggerimpuls zur Triggerung des Digitaloszilloskops erzeugt. Diejenigen Abtastwerte der digitalisierten Meßsignale werden auf einem Bildschirm der Aufzeichnungseinheit 4 des Digitaloszilloskops dargestellt, die gleichzeitig mit dem Triggerimpuls oder dem Triggerimpuls zeitlich unmittelbar nachfolgend erfasst werden.

Das erfindungsgemäße System zur digitalen Triggerung von Signalen auf der Basis von zwei zeitlich beabstandeten Triggerereignissen in der Fig. 2 weist einen ersten Komparator 5 zur Identifizierung eines ersten Triggerereignisses auf. An einen ersten Eingang 6 des ersten Komparators 5 wird ein erstes, aus allen auf dem digitalen Oszilloskop darzustellenden Signalen S ausgewähltes Referenzsignal Sᵢ geführt. Am zweiten Eingang 7 des Komparators 5 liegt ein Schwellwertsignal SWᵢ an, mit dem das erste Referenzsignal Sᵢ im ersten Komparator 5 auf Über- oder Unterschreitung verglichen wird. Der Vergleich auf Über- oder Unterschreitung im ersten Komparator 5 wird durch das am dritten Eingang 8 anliegende Signal bestimmt, das einen Vergleich auf positive oder negative Flanke kennzeichnet. Der Ausgang 9 des ersten Komparator 5 wird bei Über- oder Unterschreitung des Schwellwertsignals SWᵢ durch das erste Referenzsignal Sᵢ aktiviert.

Zur Identifizierung eines dem ersten Triggerereignis nachfolgenden zweiten Triggerereignisses ist analog ein zweiter Komparator 10 vorgesehen. An einem ersten Eingang 11 des zweiten Komparators 10 liegt entweder das am ersten Eingang 6 des ersten Komparators 5 geführte erste Referenzsignal Sᵢ oder ein zweites Referenzsignal Sⱼ an, das gegenüber dem ersten Referenzsignal Sᵢ zeitlich verzögert ist. Das am zweiten Eingang 12 des zweiten Komparators 10 anstehende Schwellwertsignal ist entweder das auch am zweiten Eingang 7 des ersten Komparators 5 anliegende Schwellwertsignal SWᵢ oder ein von diesem Schwellwertsignal SWᵢ unterschiedliches Schwellwertsignal SWⱼ. Das am dritten Eingang 13 des zweiten Komparators 10 anliegende Signal bestimmt, ob der Schwellwertvergleich im zweiten Komparator 10 zwischen dem ersten Referenzsignal Sᵢ bzw. dem zweiten Referenzsignal Sⱼ und einem der beiden Schwellwertsignale SWᵢ oder SWⱼ bei einer positiven oder negativen Flanke erfolgen soll. Der Ausgang 14 des zweiten Komparators 10 wird bei Über- oder Unterschreitung des Schwellwertsignals SWᵢ bzw. SWⱼ durch das erste oder zweiten Referenzsignal Sᵢ bzw. Sⱼ aktiviert.

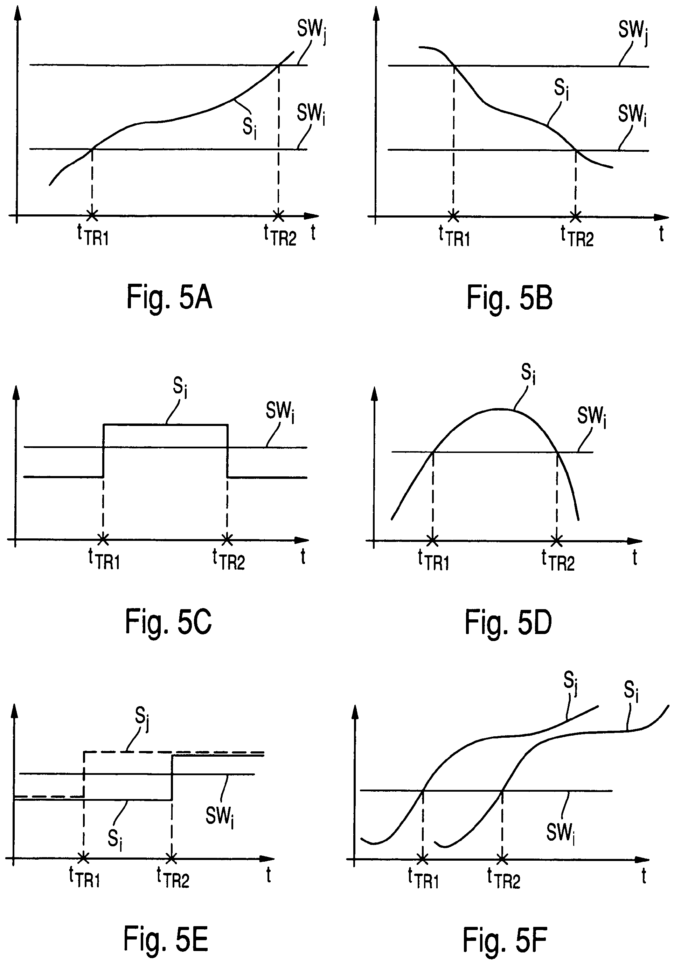

Mit dem ersten Komparator 5 und dem zweiten Komparator 10 ist es also möglich, auf der Basis von zwei zeitlich beabstandeten Triggerereignissen - erstes und zweites Triggerereignis - folgende wesentliche Triggerbedingungen einzustellen und anhand des ersten bzw. zweiten Referenzsignals Sᵢ bzw. Sⱼ zu identifizieren:
- Identifizierung einer positiven oder negativen Flanke mit einer bestimmten Mindest- oder Maximalsteigung an einem Referenzsignal Sᵢ (Fig. 5A, 5B),
- Identifizierung eines digitalen Referenzsignalimpulses Sᵢ oder eines analogen Referenzsignals Sᵢ mit einer bestimmten Mindest- oder Maximallänge (Fig. 5C, 5D) und
- Identifizierung eines Signalverzögerung mit einer bestimmten Mindest- oder Maximalverzögerung am Signalbeginn oder -ende zwischen einem ersten Referenzsignal Sᵢ und einem zum ersten Referenzsignal Sᵢ zeitlich verzögerten zweiten Referenzsignal Sⱼ (Fig. 5E, 5F).

Der Ausgang 9 des ersten Komparator 5 wird an den Start-Eingang 15 und der Ausgang 14 des zweiten Komparators 10 wird an den Stop-Eingang 16 eines Zählers 17 geleitet. An einem dritten Eingang 18 des Zählers 17 liegt die Abtastfrequenz Clk des Analog-Digital-Wandlers 2 des Digitaloszilloskops an. Der Zähler 17 zählt die Anzahl n der Abtastzeitpunkte der auf dem digitalen Oszilloskop darzustellenden Signale S zwischen dem ersten Triggerereignis (am Start-Eingang 15 des Zählers 17 anliegendes Ausgangssignal des ersten Komparators 5) und dem zweiten Triggerereignis (am Stop-Eingang 16 des Zählers 17 anliegendes Ausgangssignal des zweiten Komparators 10).

Die vom Zähler 17 gezählten Abtastzeitpunkte n zwischen erstem und zweitem Triggerereignis am Ausgang 19 des Zählers 17 werden einerseits an einen ersten Eingang 20 eines dritten Komparators 21 und andererseits an einen ersten Eingang 22 eines vierten Komparators 23 geführt. Der zweite Eingang 24 des dritten Komparators 21 erhält den in einem Register 25 abgelegten oberen Grenzwert Gwₒ. Der zweite Eingang 25 des vierten Komparators 23 wird mit dem in einem Register 26 abgelegten unteren Grenzwert GWᵤ versorgt.

Der dritte Komparator 21 vergleicht die im Zähler 17 ermittelte Anzahl n von Abtastzeitpunkten zwischen ersten und zweiten Triggerereignis mit dem oberen Grenzwert GWₒ und aktiviert den ersten Ausgang 26, falls die Anzahl n von Abtastzeitpunkten größer oder gleich dem oberen Grenzwert GWₒ ist, und aktiviert den zweiten Ausgang 27, falls die Anzahl n von Abtastzeitpunkten kleiner dem oberen Grenzwert GWₒ ist. Der vierte Komparator 23 vergleicht die im Zähler 17 ermittelte Anzahl n von Abtastzeitpunkten zwischen ersten und zweiten Triggerereignis mit dem unteren Grenzwert GWᵤ und aktiviert den ersten Ausgang 28, falls die Anzahl n von Abtastzeitpunkten größer oder gleich dem unteren Grenzwert GWᵤ ist, und aktiviert den zweiten Ausgang 29, falls die Anzahl n von Abtastzeitpunkten kleiner dem unteren Grenzwert GWᵤ ist.

Die Belegung der Register 25 und 27 mit oberen und unteren Grenzwerten GWₒ und GWᵤ, beispielsweise ersten und zweiten oberen Grenzwerten GWₒ₁, GWₒ₂ und ersten und zweiten unteren Grenzwerten GWᵤ₁, GWᵤ₂, erfolgt von einer nicht dargestellten übergeordneten Ablaufsteuerung des erfindungsgemäßen Systems zur digitalen Triggerung von Signalen auf der Basis von zwei zeitlich beabstandeten Triggerereignissen. Hierbei ist zu beachten, daß aus der vom Zähler 17 ermittelten Anzahl n von Abtastzeitpunkten zwischen ersten und zweiten Triggerereignis nicht eindeutig auf das Eintreten der Triggerbedingung oder auf das Nicht-Eintreten der Triggerbedingung geschlossen werden kann, sondern daß für bestimmte Werte der Anzahl n von Abtastzeitpunkten zwischen ersten und zweiten Triggerereignis durch eine gesonderte Feinanalyse nachträglich entweder das eindeutige Eintreten oder das eindeutige Nicht-Eintreten der Triggerbedingung ermittelt werden muß.

Dies Unbestimmtheit in der Identifizierung der Triggerbedingung resultiert aus der Ungenauigkeit in der exakten Bestimmung des ersten und zweiten Triggerereignisses - Synchronitätsfehler zwischen Abtastungsraster und präzisem ersten bzw. zweiten Triggerereignis - , die maximal bis zu einem Abtastzeitpunkt betragen kann, und aus einer Unschärfe im Schwellwertvergleich, die in der Verwendung eines ">=" oder "<=" anstelle eines ">" oder "<" Vergleichsoperators bedingt ist. Aus diesen Gründen kann der obere und untere Grenzwert maximal um den Faktor drei differieren und somit bis zu zwei dazwischenliegende Werte für die Anzahl n der Abtastzeitpunkte zwischen erstem und zweitem Triggerereignis bedingen, für die weder eine Identifizierung der Triggerbedingung eindeutig vorliegt noch eindeutig nicht vorliegt. Eine nicht dargestellte übergeordnete Ablaufsteuerung des erfindungsgemäßen Systems zur digitalen Triggerung belegt folglich die Register 25 und 26 in Übereinstimmung mit dem im Vergleich des Zeitabstandes Δt zwischen ersten und zweiten Triggerereignis mit dem Zeitschwellwert SWₜ gewählten Vergleichsoperator - ">=", "<=", ">" oder "<" - mit jeweils geeigneten oberen und unteren Grenzwerten GWₒ und Gwᵤ.

Das Signal am ersten Ausgang 26 des dritten Komparators 21 - n ≥ GWₒ - und das Signal am ersten Ausgang 28 des zweiten Komparators 23 - n ≤ GWᵤ - werden jeweils an einen der beiden Eingänge 31 und 32 eines Multiplexers 30 geführt. Der Multiplexer 30 schaltet in Abhängigkeit eines an einem dritten Eingang 33 des Multiplexers 30 anliegenden Signals, welches eine Über- oder Unterschreitung eines vorgegebenen Zeitschwellwerts SWₜ durch den Zeitabstand Δt zwischen erstem und zweitem Triggerereignis kennzeichnet, das aktivierte Signal des ersten Ausgangs 26 des dritten Komparators - n ≥ GWₒ - bei Überschreitung der Zeitschwelle SWₜ oder das aktivierte Signal des ersten Ausgangs 28 des vierten Komparators 23 - n ≤ GWᵤ - bei Unterschreitung der Zeitschwelle SWₜ an den Ausgang 34 des Multiplexers 30 durch, das als Triggerimpuls s_{TR} zur Triggerung der am digitalen Oszilloskop darzustellenden Signale S dient.

Mit dem dritten und vierten Komparator 21 und 23, den zugehörigen, den oberen und unteren Grenzwert GWₒ und GWᵤ speichernden Registern 25 und 26 und dem Multiplexer 30 ist somit eine Einheit 54 zur Identifizierung von Triggerbedingungen geschaffen.

Das aktivierte Signal am zweiten Ausgang 27 des dritten Komparators 21 - n < GWₒ - und das aktivierte Signal am zweiten Ausgang 29 des vierten Komparators 23 - n > GWᵤ - werden jeweils an einen der beiden Eingänge 35 und 36 eines UND-Gatters 37 geführt und erzeugen am Ausgang 38 das Signal FA zur Feinanalyse der Triggerbedingung In dieser Feinanalyse werden die Abtastwerte des/der Referenzsignal/e Sᵢ bzw. Sⱼ im Hinblick auf eine präzisere Bestimmung des ersten und zweiten Triggerereignisses und damit des Zeitabstandes Δt zwischen erstem und zweitem Triggerereignis ausgewertet. Ein nachfolgender Schwellwertvergleich des präziser ermittelten Zeitabstandes Δt zwischen erstem und zweitem Triggerereignis mit einem Zeitschwellwert SWₜ ermöglicht eine eindeutige Identifizierung oder Nichtidentifizierung der Triggerbedingung.

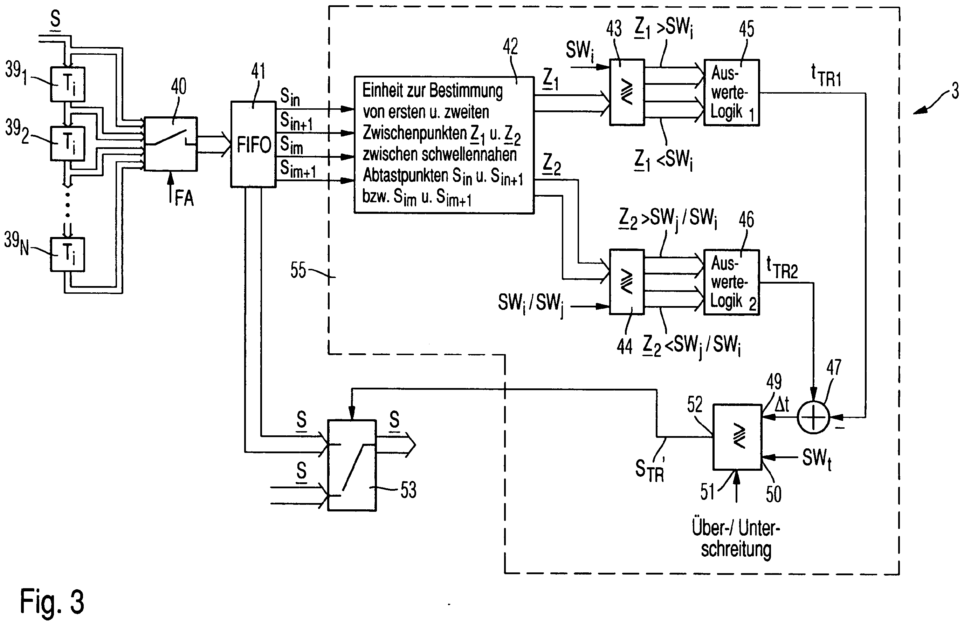

Im erfindungsgemäßen Sub-System zur Feinanalyse von Triggerbedingungen gemäß Fig. 3 werden die auf dem digitalen Oszilloskop darzustellenden Abtastwerte der Signale S mehreren in Serie geschalteten Verzögerungsgliedern 39₁, 39₂,...,39_{N} zugeführt, in denen sie jeweils um die Abtastzeit Tᵢ des Analog-Digital-Wandlers 2 verzögert werden. Die an den einzelnen Ausgängen der einzelnen Verzögerungsglieder 39₁, 39₂,..., 39_{N} anliegenden Signale, die jeweils um eine unterschiedliche Anzahl von Abtastzyklen Tᵢ zueinander verzögert sind und somit die seit der Identifizierung des ersten Triggerereignisses zwischengespeicherten Abtastwerte der auf dem digitalen Oszilloskop darzustellenden Signale S darstellen, werden an den Eingang eines Schalters 40 geleitet und bei aktivierten Signal FA für eine Feinanalyse der Triggerbedingung an einen first-in-first-out-Speicher (FIFO-Speicher) 41 weitergeschaltet, in dem sie zwischengespeichert werden.

Aus dem FIFO-Speicher 41 werden von einer nicht dargestellten Ablaufsteuerung des erfindungsgemäßen Systems zur digitalen Triggerung der dem ersten identifizierten Triggerereignis zuletzt vorausgehende und nächst folgende Abtastwert Sᵢₙ und Sᵢₙ₊₁ des ersten Referenzsignals Sᵢ und der dem zweiten identifizierten Triggerereignis zuletzt vorausgehende und nächst folgende Abtastwert Sᵢₘ und Sᵢₘ₊₁ bzw. Sⱼₘ und Sⱼₘ₊₁ des ersten bzw. zweiten Referenzsignals Sᵢ bzw. Sⱼ ausgelesen und einer Einheit 42 zur Bestimmung von ersten und zweiten Zwischenpunkten Z₁ und Z₂ zwischen den schwellwertnahen Abtastwerten Sᵢₙ und Sᵢₙ₊₁ sowie Sᵢₘ und Sᵢₘ₊₁ bzw. Sⱼₘ bzw. Sⱼₘ₊₁ des ersten bzw. zweiten Referenzsignals Sᵢ bzw. Sⱼ zugeführt. In der Einheit 42 werden über bestimmte Interpolationsverfahren, auf die in diesem Zusammenhang nicht näher eingegangen wird, die Pegel von Zwischenpunkten Z₁ und Z₂ berechnet und im Hinblick auf eine präzisere Bestimmung des ersten und zweiten Triggerereignisses einem fünften und sechsten Komparator 43 und 44 zugeführt.

Im fünften Komparator 43 erfolgt ein Schwellwertvergleich der ersten Zwischenpunkte Z₁ mit einem Schwellwert SWᵢ, während im sechsten Komparator 44 ein Schwellwertvergleich der zweiten Zwischenpunkte Z₂ mit dem gleichen Schwellwert SWᵢ - im Fall einer Identifizierung eines Signalimpulses mit einer bestimmten Impulslänge oder mit einer bestimmter Signalverzögerung - oder mit einem weiteren Schwellwert SWⱼ - im Fall einer Identifizierung einer Signalflanke - durchgeführt wird.

Die entsprechend der Anzahl von ersten Zwischenpunkten Z₁ jeweils für Über- und Unterschreitung des Schwellwerts SWᵢ vorgesehenen Ausgänge Z₁>SWᵢ und Z₁<SWᵢ, die bei Vorliegen der jeweiligen Vergleichsbedingung jeweils aktiviert sind, werden in einer nachfolgenden ersten Auswertelogik 45 zur Bestimmung des präziseren Zeitpunkts t_{TR1} des ersten Triggerereignisses ausgewertet. Analog werden die entsprechend der Anzahl von zweiten Zwischenpunkten Z₂ jeweils für Über- und Unterschreitung des Schwellwerts SWᵢ bzw. SWⱼ vorgesehenen Ausgänge Z₂>SWᵢ bzw. Z₂>SWⱼ und Z₁<SWᵢ bzw. Z₂<SWⱼ, die bei Vorliegen der jeweiligen Vergleichsbedingung jeweils aktiviert sind, in einer nachfolgenden zweiten Auswertelogik 46 zur Bestimmung des präziseren Zeitpunkts t_{TR2} des zweiten Triggerereignisses ausgewertet.

Ein nachfolgendes Subtrahierglied 47 berechnet den Zeitabstand Δt zwischen erstem und zweitem Triggerereignis aus der Differenz des Zeitpunkts t_{TR2} des zweiten Triggerereignisses und des Zeitpunkts t_{TR1} des ersten Triggerereignisses. Dieser Zeitabstand Δt wird an einen ersten Eingang 49 eines nachfolgenden siebten Komparators 48 geführt und mit einem am zweiten Eingang 50 anliegenden Zeitschwellwert SWₜ auf Über- oder Unterschreitung verglichen. Hierzu wird an einem dritten Eingang 51 des siebten Komparators 48 das am dritten Eingang 33 des Multiplexers 30 anliegende Signal geführt, das einen Vergleich auf Über- oder Unterschreitung des Zeitschwellwerts SWₜ kennzeichnet. Bei Eintritt der Vergleichsbedingung wird am Ausgang 52 des siebten Komparators 48 ein Triggerimpuls s_{TR}' aktiviert, der über einen Multiplexer 53 die seit dem Eintreten des ersten Triggerereignisses im FIFO-Speicher 41 zwischengespeicherten Abtastwerte der auf dem digitalen Oszilloskop darzustellenden Signale S verzögert und die Auswertungszeit der Feinanalyse anstelle der aktuell vorverstärkten und abgetasteten Signale S an die Aufzeichnungseinrichtung 4 des digitalen Oszilloskops weiterleitet.

Mit der Einheit 42 zur Bestimmung von ersten und zweiten Zwischenpunkten Z₁ und Z₂ zwischen schwellwertnahen Abtastpunkten Sᵢₙ, Sᵢₙ₊₁, Sᵢₘ und Sᵢₘ₊₁, dem fünften und sechsten Komparator 43 und 44, der ersten und zweiten Auswertelogik 45 und 46, dem Subtrahierglied 47 und dem siebten Komparator 48 ist eine Einheit 55 zur Feinidentifizierung von Triggerbedingungen geschaffen.

In Fig. 4 ist das Blockschaltbild des erfindungsgemäßen digitalen Oszilloskops zusammen mit den bereits in Fig. 3 anhand des System zur Feinanalyse der Triggerbedingungen vorgestellten Funktionseinheiten dargestellt. Auf eine wiederholte Beschreibung dieser Funktionseinheiten wird deshalb an dieser Stelle verzichtet.

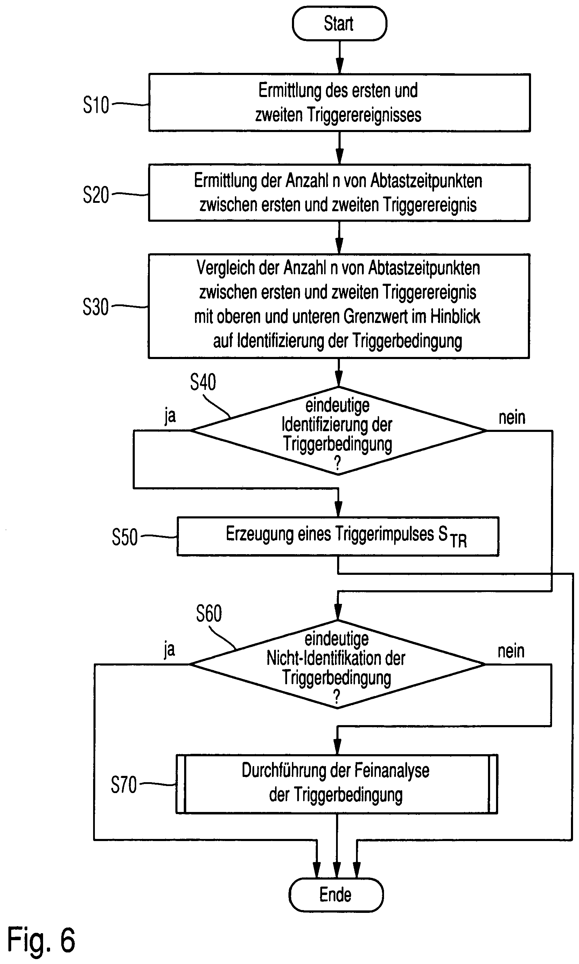

In Fig. 6 ist das erfindungsgemäße Verfahren zur digitalen Triggerung von Signalen auf der Basis von zwei zeitlich beabstandeten Triggerereignissen dargestellt.

In ersten Verfahrensschritt S10 werden mittels eines ersten und zweiten Komparators 5 und 10 aus einem aus allen auf dem digitalen Oszilloskope darzustellenden Signalen S ausgewählten ersten Referenzsignal Sᵢ bzw. zusätzlich ausgewählten zweiten Referenzsignal Sⱼ mittels Schwellwertvergleich mit einem ersten Schwellwertsignal swᵢ bzw. zusätzlich mit einem zweiten Schwellwertsignal SWⱼ das erste und zweite Triggerereignisses mit einer Genauigkeit in Höhe der Abtastperiode der auf den digitalen Oszilloskop darzustellenden Signale S ermittelt.

Mit dem im Verfahrensschritt S10 ermittelten ersten und zweiten Triggerereignis wird mit einem Zähler 17 die Anzahl n der Abtastzeitpunkte der auf dem digitalen Oszilloskop darzustellenden Signale S zwischen erstem und zweitem Triggerereignis in Verfahrensschritt S20 gezählt.

Die in Verfahrensschritt S20 ermittelte Anzahl n von Abtastzeitpunkten zwischen erstem und zweitem Triggerereignis wird in Verfahrensschritt S30 mit einem oberen und unteren Grenzwert GWₒ und GWᵤ auf Über- oder Unterschreitung im Hinblick auf eine eindeutige Identifizierung oder eindeutige Nichtidentifizierung der Triggerbedingung verglichen. Hierbei werden von einer übergeordneten Ablaufsteuerung des erfindungsgemäßen Systems zur digitalen Triggerung die oberen und unteren Grenzwerte GWₒ und GWᵤ entsprechend des vom Anwender oder vom System beim Schwellwertvergleich des Zeitabstandes Δt zwischen ersten und zweiten Triggerzeitpunkt gewählten Vergleichsoperators - ">=", "<=", ">" oder "<" - ausgewählt.

Ergibt der Grenzwertvergleich der Anzahl n von Abtastzeitpunkten zwischen erstem und zweitem Triggerereignis in Verfahrensschritt S40 eine eindeutige Identifizierung der Triggerbedingung, so wird im darauf folgenden Verfahrensschritt S50 ein Triggerimpuls s_{TR} zur Triggerung der auf dem digitalen Oszilloskop darzustellenden Signale S erzeugt.

Ergibt der Grenzwertvergleich in Verfahrensschritt S60 auch keine eindeutige Nichtidentifizierung der Triggerbedingung, so ist im Rahmen eines Unterverfahrens S70 eine Feinanalyse der Triggerbedingung durchzuführen, die eine eindeutige nachträgliche Identifizierung oder eine eindeutige nachträgliche Nichtidentifizierung der Triggerbedingung zum Ziel hat.

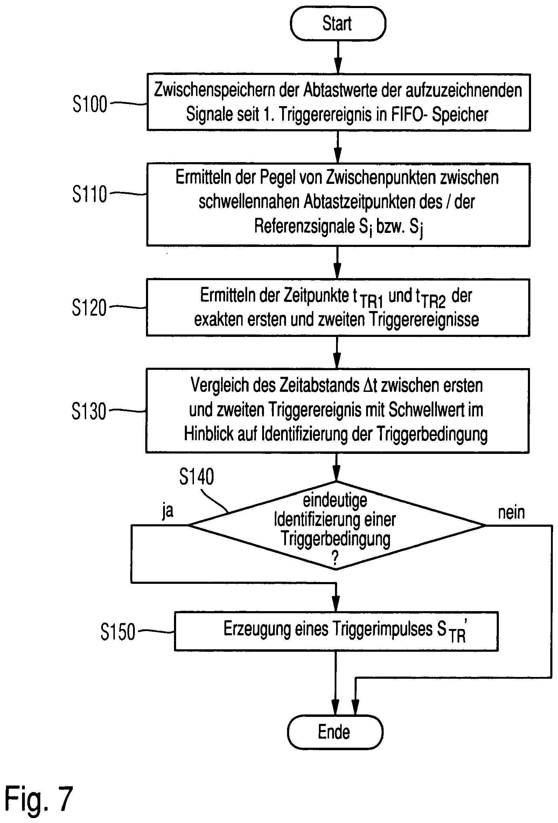

Das erfindungsgemäße Unterverfahren zur Feinanalyse der Triggerbedingung, welches im erfindungsgemäßen Verfahren zur digitalen Triggerung von Signalen auf der Basis von zwei zeitlich beabstandeten Triggerereignissen in Fig. 6 als Verfahrensschritt S70 aufgeführt ist, wird in Fig. 7 im Detail beschrieben.

Der erste Verfahrensschritt S100 des erfindungsgemäßen Unterverfahrens zur Feinanalyse der Triggerbedingung in Fig. 7 beinhaltet das Zwischenspeichern sämtlicher Abtastwerte der auf dem digitalen Oszilloskop darzustellenden Signale S in einem first-in-first-out-Speicher 41 ab dem Zeitpunkt der Identifizierung des ersten Triggerereignisses.

Im darauf folgenden Verfahrensschritt S110 werden mittels eines Interpolationsverfahrens die Pegel des ersten Zwischenpunkts Z₁, die zwischen dem dem ersten Triggerereignis letzt vorausgehenden und dem dem ersten Triggerereignis nächst folgenden Abtastzeitpunkt des ersten Referenzsignals Sᵢ liegen, und die Pegel des zweiten Zwischenpunkts Z₂ bestimmt, die zwischen dem dem zweiten Triggerereignis letzt vorausgehenden und dem dem zweiten Triggerereignis nächst folgenden Abtastzeitpunkt des ersten oder zweiten Referenzsignals Sᵢ oder Sⱼ liegen.

Durch Vergleich der ersten und zweiten Zwischenwerte Z₁ und Z₂ mit einem Schwellwertsignal SWᵢ bzw. mit einem zusätzlichen Schwellwertsignal SWⱼ werden in einem fünften und sechsten Komparator 43 und 44 und einer ersten und zweiten Auswertelogik 45 und 46 die Zeitpunkte t_{TR1} und t_{TR2} des ersten und zweiten Triggerereignisses in Verfahrensschritt S120 ermittelt.

Auf der Basis der ermittelten Zeitpunkte t_{TR1} und t_{TR2} des ersten und zweiten Triggerereignisses wird in Verfahrensschritt S130 der Zeitabstand Δt zwischen dem ersten und zweiten Triggerereignis in einem Subtrahierglied 47 ermittelt und anschließend in einem siebten Komparator 48 mit einem Zeitschwellwert SWₜ auf Über- oder Unterschreitung verglichen, um die Triggerbedingung eindeutig zu identifizieren oder eindeutig nicht zu identifizieren.

Liegt in Verfahrensschritt S140 aufgrund des Schwellwertvergleichs in Verfahrensschritt S130 eine eindeutige Identifizierung der Triggerbedingung vor, so wird im abschließenden Verfahrensschritt S150 ein Triggerimpuls s_{TR}' zur Triggerung der im FIFO-Speicher 41 seit dem identifizierten ersten Triggerereignis zwischengespeicherten Abtastwerte der auf den digitalen Oszilloskop darzustellenden Signale S erzeugt.

Die Erfindung ist nicht auf die dargestellte Ausführungsform beschränkt. Insbesondere sind von der Erfindung auch andere numerische Verfahren zur Bestimmung präziserer Zeitpunkte des ersten und zweiten Triggerereignisses, insbesondere laufzeitoptimierte Verfahren, abgedeckt.

## Patentansprüche

1. Verfahren zur digitalen Triggerung einer Aufzeichnung eines oder mehrerer zu einzelnen Abtastzeitpunkten abgetasteter Signale (S) auf einem digitalen Oszilloskop, bei dem die digitale Triggerung erfolgt, falls der Zeitabstand (Δt) zwischen zwei auftretenden Triggerereignissen, der aus der Anzahl (n) von Abtastzeitpunkten der abgetasteten Signale (S) zwischen den beiden Triggerereignissen ermittelt wird, einen Zeitschwellwert (SWₜ) über- oder unterschreitet,
**dadurch gekennzeichnet,**
**dass** im Fall einer weder eindeutigen Identifizierung noch einer eindeutigen Nichtidentifizierung eines Über- oder Unterschreitens des Zeitschwellwerts (SWₜ) durch den Zeitabstand (Δt) zwischen zwei auftretenden Triggerereignissen, wenn die Anzahl (n) von Abtastzeitpunkten zwischen den beiden Triggerereignissen zwischen einem oberen Grenzwert (GWₒ₁,GWₒ₂) und unteren Grenzwert (GWᵤ₁,GWᵤ₂) liegt, die einzelnen Abtastwerte der auf dem digitalen Oszilloskop aufzuzeichnenden abgetasteten Signale (S) zwischengespeichert und einer nachfolgenden Feinanalyse unterzogen werden, und
**dass** die seit der Identifizierung eines ersten Triggerereignisses zwischengespeicherten Abtastwerte der auf dem digitalen Oszilloskop darzustellenden Signale (S) jeweils um eine unterschiedliche Anzahl von Abtastzyklen (Tᵢ) zueinander verzögert werden und für die Feinanalyse der Triggerbedingung an einen first-in-first-out-Speicher (41) weitergeschaltet werden, in dem sie zwischengespeichert werden.

2. Verfahren zur digitalen Triggerung nach Anspruch 1,
**dadurch gekennzeichnet,**
**dass** das Triggerereignis ein Über- oder Unterschreiten eines von mehreren Schwellwerten (SWᵢ, SWⱼ) durch eines von mehreren Referenzsignalen (Sᵢ, Sⱼ) ist, welches aus den auf dem digitalen Oszilloskop aufzuzeichnenden abgetasteten Signalen (S) ausgewählt werden.

3. Verfahren zur digitalen Triggerung nach Anspruch 2,
**dadurch gekennzeichnet,**
**dass** die Überschreitung des Zeitschwellwerts (SWₜ) durch den Zeitabstand (Δt) zwischen den beiden Triggerereignissen eindeutig identifiziert ist, wenn die Anzahl (n) der ermittelten Abtastzeitpunkte einen ersten oberen Grenzwert (GWₒ₁) überschreitet.

4. Verfahren zur digitalen Triggerung nach Anspruch 2 oder 3,
**dadurch gekennzeichnet,**
**dass** die Überschreitung des Zeitschwellwerts (SWₜ) durch den Zeitabstand (Δt) zwischen den beiden Triggerereignissen eindeutig nicht identifiziert ist, wenn die Anzahl (n) der ermittelten Abtastzeitpunkte einen ersten unteren Grenzwert (GWᵤ₁) unterschreitet.

5. Verfahren zur digitalen Triggerung nach Anspruch 2 bis 4,
**dadurch gekennzeichnet,**
**dass** die Unterschreitung des Zeitschwellwerts (SWₜ) durch den Zeitabstand (Δt) zwischen den beiden Triggerereignissen eindeutig identifiziert ist, wenn die Anzahl (n) der ermittelten Abtastzeitpunkte einen zweiten unteren Grenzwert (GWᵤ₂) unterschreitet.

6. Verfahren zur digitalen Triggerung nach einem der Ansprüche 2 bis 5,
**dadurch gekennzeichnet,**
**dass** die Unterschreitung des Zeitschwellwerts (SWₜ) durch den Zeitabstand (Δt) zwischen den beiden Triggerereignissen eindeutig nicht identifiziert ist, wenn die Anzahl (n) der ermittelten Abtastzeitpunkte einen zweiten oberen Grenzwert (GWₒ₂) überschreitet.

7. Verfahren zur digitalen Triggerung nach Anspruch 3 oder 5,
**dadurch gekennzeichnet,**
**dass** im Fall einer eindeutigen Identifizierung der Über- oder Unterschreitung des Zeitschwellwerts (SWₜ) durch den Zeitabstand (Δt) zwischen den beiden Triggerereignissen die Aufzeichnung eines oder mehrerer Signale (S) auf dem digitalen Oszilloskop gestartet wird.

8. Verfahren zur digitalen Triggerung nach Anspruch 3 oder 4,
**dadurch gekennzeichnet,**
**dass** die Überschreitung des Schwellwerts (SWₜ) durch den Zeitabstand (Δt) zwischen den beiden Triggerereignissen weder eindeutig identifiziert noch eindeutig nicht identifiziert ist, wenn die Anzahl (n) der ermittelten Abtastzeitpunkte zwischen dem ersten unteren und oberen Grenzwert (GWᵤ₁, GWₒ₁) liegt.

9. Verfahren zur digitalen Triggerung nach Anspruch 5 oder 6,
**dadurch gekennzeichnet,**
**dass** die Unterschreitung des Schwellwerts (SWₜ) durch den Zeitabstand (Δt) zwischen den beiden Triggerereignissen weder eindeutig identifiziert noch eindeutig nicht identifiziert ist, wenn die Anzahl (n) der ermittelten Abtastzeitpunkte zwischen dem zweiten unteren und oberen Grenzwert (GWᵤ₂, GWₒ₂) liegt.

10. Verfahren zur digitalen Triggerung nach einem der Ansprüche 1 bis 9,
**dadurch gekennzeichnet,**
**dass** von den einzelnen zwischengespeicherten Abtastwerten der auf dem digitalen Oszilloskop aufzuzeichnenden abgetasteten Signale (S) die zwischengepeicherten schwellwertnahen Abtastwerte (Sᵢₙ, Sᵢₙ₊₁, Sᵢₘ, Sᵢₘ₊₁, Sⱼₘ, Sⱼₘ₊₁) der ausgewählten ersten und zweiten Referenzsignale (Sᵢ, Sⱼ) einer nachfolgenden Feinanalyse unterzogen werden.

11. Verfahren zur digitalen Triggerung nach Anspruch 10,
**dadurch gekennzeichnet,**
**dass** in der Feinanalyse zwischen dem dem ersten Triggerereignis letzt vorausgehenden Abtastzeitpunkt (in) und dem dem ersten Triggerereignis nächst folgenden Abtastzeitpunkt (in+1) des ausgewählten ersten Referenzsignals (Sᵢ) über eine Interpolation in äquidistanten Zeitabständen die Pegel von mehreren ersten Zwischenpunkten (Z₁) ermittelt werden.

12. Verfahren zur digitalen Triggerung nach Anspruch 10 oder 11,
**dadurch gekennzeichnet,**
**dass** in der Feinanalyse zwischen dem dem zweiten Triggerereignis letzt vorausgehenden Abtastzeitpunkt (im, jm) und dem dem zweiten Triggerereignis nächst folgenden Abtastzeitpunkt (im+1,jm+1) des ausgewählten ersten oder zweiten Referenzsignals (Sᵢ, Sⱼ) über eine Interpolation in äquidistanten Zeitabständen die Pegel von mehreren zweiten Zwischenpunkten (Z₂) ermittelt werden.

13. Verfahren zur digitalen Triggerung nach Anspruch 12,
**dadurch gekennzeichnet,**
**dass** mittels Vergleichs der Pegel der ersten bzw. zweiten Zwischenpunkte (Z₁, Z₂) mit jeweils einem Schwellwert (SWᵢ, SWⱼ) auf Über- oder Unterschreitung derjenige erste bzw. zweite Zwischenpunkt (Z₁, Z₂) als erstes bzw. zweites Triggerereignis identifiziert wird, der den kürzesten Pegelabstand zum zugehörigen Schwellwert (SWᵢ, SWⱼ) aufweist.

14. Verfahren zur digitalen Triggerung nach Anspruch 13,
**dadurch gekennzeichnet,**
**dass** der Zeitabstand (Δt) zwischen dem ersten und zweiten Triggerereignis mit dem Zeitschwellwert (SWₜ) auf Über- oder Unterschreitung verglichen wird.

15. Verfahren zur digitalen Triggerung nach Anspruch 14,
**dadurch gekennzeichnet,**
**dass** in Abhängigkeit einer Über- oder Unterschreitung des Zeitschwellwerts (SWₜ) durch den Zeitabstand (Δt) zwischen erstem und zweitem Triggerereignis die Aufzeichnung der zwischengespeicherten Abtastwerte der auf dem digitalen Oszilloskop aufzuzeichnenden abgetasteten Signale (S) auf dem digitalen Oszilloskop gestartet wird.

16. System zur digitalen Triggerung einer Aufzeichnung eines oder mehrerer abgetasteter Signale (S) auf einem digitalen Oszilloskop, mit einer digitalen Triggerung im Fall einer Über- oder Unterschreitung eines Zeitschwellwerts (SWₜ) durch den Zeitabstand (Δt) zwischen zwei auftretenden Triggerereignissen mit mindestens einem Komparator (5, 10) zum Vergleich von mindestens einem aus den auf dem digitalen Oszilloskop aufzuzeichnenden abgetasteten Signalen (S) ausgewählten Referenzsignal (Sᵢ, Sⱼ) mit mindestens einem Schwellwert (SWᵢ, SWⱼ) auf Über- oder Unterschreitung, und einer dem Komparator (5, 10) nachfolgenden Einheit (54) zur Identifizierung von Triggerbedingungen,
**dadurch gekennzeichnet,**
**dass** von einer Einheit (55) zur Feinidentifizierung von Triggerbedingungen im Fall einer fehlenden eindeutigen Identifizierung oder fehlenden eindeutigen Nichtidentifizierung einer Triggerbedingung durch die Einheit (54) zur Identizierung von Triggerbedingungen eine endgültige eindeutige Identifizierung oder endgültige eindeutige Nichtidentifizierung einer Triggerbedingung verwirklicht wird, und
**dass** die seit der Identifizierung eines ersten Triggerereignisses zwischengespeicherten Abtastwerte der auf dem digitalen Oszilloskop darzustellenden Signale (S) jeweils um eine unterschiedliche Anzahl von Abtastzyklen (Tᵢ) zueinander verzögert sind und für die Feinanalyse der Triggerbedingung an einen first-in-first-out-Speicher (41) weitergeschaltet sind, in dem sie zwischengespeichert werden.

17. System zur digitalen Triggerung nach Anspruch 16,
**dadurch gekennzeichnet,**
**dass** zur Ermittlung des ersten Triggerereignisses ein erstes Referenzsignal (Sᵢ) in einem ersten Komparator (5) mit einem Schwellwert (SWᵢ) und zur Ermittlung des zweiten Triggerereignisses ein erstes oder zweites Referenzsignal (Sᵢ, Sⱼ) in einem zweiten Komparator (10) mit einem der Schwellwerte (SWᵢ, SWⱼ) jeweils auf Über- oder Unterschreitung verglichen wird.

18. System zur digitalen Triggerung nach Anspruch 16 oder 17,
**dadurch gekennzeichnet,**
**dass** zur Ermittlung des Zeitabstands (Δt) zwischen dem ersten und zweiten Triggerereignis in einem Zähler (17) die Anzahl (n) von Abtastzeitpunkten der aufzuzeichnenden abgetasteten Signale (S) zwischen dem ersten und zweiten Triggerereignis gezählt werden.

19. System zur digitalen Triggerung nach Anspruch 18,
**dadurch gekennzeichnet,**
**dass** in der Einheit (54) zur Identifizierung von Triggerbedingungen die Über- oder Unterschreitung des Zeitschwellwerts (SWₜ) durch den Zeitabstand (Δt) zwischen dem ersten und zweiten Triggerereignis durch Vergleich der in deren Zeitabstand (Δt) enthaltenenen Abtastzeitpunkte (n) der aufzuzeichnenden abgetasteten Signale (S) mit einem oberen und unteren Grenzwert (GWₒ₁, GWₒ₂, GWᵤ₁, GWᵤ₂) erfolgt.

20. System zur digitalen Triggerung nach einem der Ansprüche 16 bis 19,
**dadurch gekennzeichnet,**
**dass** die Einheit (54) zur Identifizierung von Triggerbedingungen eine eindeutige Identifizierung, eine eindeutige Nicht-Identifizierung oder weder eine eindeutige Identifizierung noch eine eindeutige Nicht- Identifizierung der Über- oder Unterschreitung des Zeitschwellwerts (SWₜ) durch den Zeitabstand (Δt) zwischen dem ersten und zweiten Triggerereignis realisiert.

21. System zur digitalen Triggerung nach Anspruch 20,
**dadurch gekennzeichnet,**
**dass** die Abtastwerte der auf dem digitalen Oszilloskop aufzuzeichnenden abgetasteten Signale (S) in dem first-in-first-out-Speicher (41) zwischengespeichert werden, falls von der Einheit (54), zur Identifizierung von Triggerbedingungen eine Über- oder Unterschreitung des Zeitschwellwerts (SWₜ) durch den Zeitabstand (Δt) zwischen dem ersten und zweiten Triggerereignis weder eindeutig identifiziert noch eindeutig nicht identifiziert wird.

22. Digitales Oszilloskop bestehend aus einem Vorverstärker (1) zur Pegelanpassung von mindestens einem auf dem digitalen Oszilloskop aufzuzeichnenden Signal (S), einem Analog-Digital-Wandler (2) zur Analag-DigitalWandlung der aufzuzeichnenden Signale (S), einem System zur digitalen Triggerung (3) nach einem der Ansprüche 16 bis 21 und einer Aufzeichnungseinheit (4) zur Darstellung der aufzuzeichnenden abgetasteten Signale (S).

## Claims

1. Method for digital triggering of a recording of one or more signals (S) sampled at individual sampling times on a digital oscilloscope, wherein the digital triggering is carried out if the time gap (Δt) between two triggering events occurring which is determined from the number (n) of sampling times of the sampled signals (S) between the two triggering events, overshoots or undershoots a time threshold value (SWₜ),
**characterised in that**
in the event of neither unambiguous identification nor unambiguous non-identification of an overshooting or undershooting of the time threshold value (SWₜ) by the time gap (Δt) between two triggering events occurring when the number (n) of sampling times between the two triggering events lies between an upper limit value (GWₒ₁, GWₒ₂) and a lower limit value (GWᵤ₁, GWᵤ₂), the individual sampled values of the sampled signals (S) to be recorded on the digital oscilloscope are temporarily stored and subjected to a following fine analysis, and **in that** the sampled values of the signals (S) to be displayed on the digital oscilloscope temporarily stored since the identification of a first triggering event are in each case delayed in relation to one another by a different number of sampling cycles (Tᵢ) and passed on for the fine analysis of the triggering condition to a first-in/first-out memory (41) in which they are temporarily stored.

2. Method for digital triggering according to claim 1,
**characterised in that**
the triggering event is an overshooting or undershooting of one of a plurality of threshold values (SWᵢ, SWⱼ) by one of a plurality of reference signals (Si, Sⱼ) which are selected from the sampled signals (S) to be recorded on the digital oscilloscope.

3. Method for digital triggering according to claim 2,
**characterised in that**
the overshooting of the time threshold value (SWₜ) by the time gap (Δt) between the two triggering events is unambiguously identified when the number (n) of the determined sampling times overshoots a first upper limit value (GWₒ₁).

4. Method for digital triggering according to claim 2 or 3,
**characterised in that**
the overshooting of the time threshold value (SWₜ) by the time gap (Δt) between the two triggering events is unambiguously not identified when the number (n) of the determined sampling times undershoots a first lower limit value (GWᵤ₁).

5. Method for digital triggering according to claims 2 to 4,
**characterised in that**
the undershooting of the time threshold value (SWₜ) by the time gap (Δt) between the two triggering events is unambiguously identified when the number (n) of the determined sampling times undershoots a second lower limit value (GWᵤ₂).

6. Method for digital triggering according to one of claims 2 to 5,
**characterised in that**
the undershooting of the time threshold value (SWₜ) by the time gap (Δt) between the two triggering events is unambiguously not identified when the number (n) of the determined sampling times overshoots a second upper limit value (GWₒ₂).

7. Method for digital triggering according to claim 3 or 5,
**characterised in that**
in the event of unambiguous identification of the overshooting or undershooting of the time threshold value (SWₜ) by the time gap (Δt) between the two triggering events, the recording of one or more signals (S) on the oscilloscope is started.

8. Method for digital triggering according to claim 3 or 4,
**characterised in that**
the overshooting of the threshold value (SWₜ) by the time gap (Δt) between the two triggering events is neither unambiguously identified nor unambiguously not identified when the number (n) of the determined sampling times lies between the first lower and upper limit value (GWᵤ₁, GWₒ₁).

9. Method for digital triggering according to claim 5 or 6,
**characterised in that**
the undershooting of the threshold value (SWₜ) by the time gap (Δt) between the two triggering events is neither unambiguously identified nor unambiguously not identified when the number (n) of the determined sampling times lies between the second lower and upper limit value (GWᵤ₂, GWₒ₂).

10. Method for digital triggering according to one of claims 1 to 9,
**characterised in that**
of the individual temporarily stored sampled values of the sampled signals (S) to be recorded on the digital oscilloscope the temporarily stored sampled values close to the threshold (Sᵢₙ, Sᵢₙ₊₁, Sᵢₘ, Sᵢₘ₊₁, Sⱼₘ, Sⱼₘ₊₂) of the selected first and second reference signals (Sᵢ, Sⱼ) are subjected to a following fine analysis.

11. Method for digital triggering according to claim 10,
**characterised in that**
in the fine analysis between the last sampling time (in) preceding the first triggering event and the next sampling time (in+1) following the first triggering event of the selected first reference signal (Si) the levels of a plurality of first intermediate points (Z₁) are determined by means of interpolation in equidistant time gaps.

12. Method for digital triggering according to claim 10 or 11,
**characterised in that**
in the fine analysis between the last sampling time (im, jm) preceding the second triggering event and the next sampling time (im+1, jm+1) following the second triggering event of the selected first or second reference signal (Sᵢ,Sⱼ) the levels of a plurality of second intermediate points (Z₂) are determined by means of interpolation in equidistant time gaps.

13. Method for digital triggering according to claim 12,
**characterised in that**
by comparing the levels of the first or second intermediate points (Z₁, Z₂) with in each case a threshold value (SWi, SWⱼ) to identify overshooting or undershooting, the first or second intermediate point (Z₁, Z₂) having the level with the shortest gap to the associated threshold value (SWᵢ, SWⱼ) is identified as the first or second triggering event respectively.

14. Method for digital triggering according to claim 13,
**characterised in that**
the time gap (Δt) between the first and second triggering event is compared with the time threshold value (SWₜ) to identify overshooting or undershooting.

15. Method for digital triggering according to claim 14,
**characterised in that**
the recording of the temporarily stored sampled values of the sampled signals (S) to be recorded on the digital oscilloscope is started depending on the overshooting or undershooting of the time threshold value (SWₜ) by the time gap (Δt) between the first and second triggering event.

16. System for digital triggering of a recording of one or more sampled signals (S) on a digital oscilloscope, with digital triggering if the time gap (Δt) between two triggering events occurring overshoots or undershoots a time threshold value (SWₜ), with at least one comparator (5, 10) for comparing at least one reference signal (Si, Sⱼ) selected from the sampled signals (S) to be recorded on the digital oscilloscope with at least one threshold value (SWᵢ, SWⱼ) to identify overshooting or undershooting, and a unit (54) for identifying triggering conditions following the comparator (5, 10),
**characterised in that**
definitive unambiguous identification or definitive unambiguous non-identification of a triggering condition is realised by a unit (55) for fine identification of triggering conditions in the event of the absence of unambiguous identification or the absence of unambiguous non-identification of a triggering condition by the unit (54) for identifying triggering conditions, and
**in that** the sampled values of the signals (S) to be displayed on the digital oscilloscope temporarily stored since the identification of a first triggering event are in each case delayed in relation to one another by a different number of sampling cycles (Tᵢ) and passed on for the fine analysis of the triggering condition to a first-in/first-out memory (41) in which they are temporarily stored.

17. System for digital triggering according to claim 16,
**characterised in that**
to determine the first triggering event a first reference signal (Sᵢ) is compared with a threshold value (SWᵢ) in a first comparator (5) and to determine the second triggering event a first or second reference signal (Sᵢ, Sⱼ) is compared with one of the threshold values (SWᵢ, SWⱼ) in a second comparator (10) in each case to identify overshooting or undershooting.

18. System for digital triggering according to claim 16 or 17,
**characterised in that**
to determine the time gap (Δt) between the first and second triggering event the number (n) of sampling times of the sampled signals (S) to be recorded between the first and second triggering event is counted in a counter (17).

19. System for digital triggering according to claim 18,
**characterised in that**
in the unit (54) for identifying triggering conditions the overshooting or undershooting of the time threshold value (SWₜ) by the time gap (Δt) between the first and second triggering event is effected by comparing the sampling times (n) contained in the time gap (Δt) of the sampled signals (S) to be recorded with an upper and lower limit value (GWₒ₁, GWₒ₂, GWᵤ₁, GWᵤ₂).

20. System for digital triggering according to one of claims 16 to 19,
**characterised in that**
the unit (54) for identifying triggering conditions realises an unambiguous identification, an unambiguous non-identification or neither an unambiguous identification nor an unambiguous non-identification of the overshooting or undershooting of the time threshold value (SWₜ) by the time gap (Δt) between the first and second triggering event.

21. System for digital triggering according to claim 20,
**characterised in that**
the sampled values of the sampled signals (S) to be recorded on the digital oscilloscope are temporarily stored in the first-in/first-out memory (41) in the event of neither unambiguous identification nor unambiguous non-identification by the unit (54) for identifying triggering conditions of the overshooting or undershooting of the time threshold value (SWₜ) by the time gap (Δt) between the first and second triggering event.

22. Digital oscilloscope comprising a pre-amplifier (1) for matching the level of at least one signal (S) to be recorded on the digital oscilloscope, an analogue-to-digital converter (2) for analogue-to-digital conversion of the signals (S) to be recorded, a system for digital triggering (3) according to one of claims 16 to 21 and a recording unit (4) for displaying the sampled signals (S) to be recorded.

## Revendications

1. Procédé de déclenchement numérique d'un enregistrement d'un ou de plusieurs signaux (S) échantillonnés à différents moments d'échantillonnage sur un oscilloscope numérique, selon lequel le déclenchement numérique est réalisé au cas où l'intervalle de temps (Δt) entre deux événements de déclenchement survenus, qui est déterminé à partir du nombre (n) de moments d'échantillonnage des signaux (S) échantillonnés entre les deux événements de déclenchement, dépasserait ou n'atteindrait pas une valeur seuil temporelle (SWₜ),
**caractérisé en ce que**,
au cas où un dépassement ou une non-atteinte de la valeur seuil temporelle (SWₜ) par l'intervalle de temps (Δt) entre deux événements de déclenchement survenus ne serait ni identifié(e) clairement ni non identifié(e) clairement, lorsque le nombre (n) de moments d'échantillonnage entre les deux événements de déclenchement se situe entre une valeur limite supérieure (GWₒ₁, GWₒ₂) et une valeur limite inférieure (GWᵤ₁, GWᵤ₂), les différentes valeurs d'échantillonnage des signaux (S) échantillonnés à enregistrer sur l'oscilloscope numérique sont mises en mémoire temporairement et soumises à une analyse fine subséquente, et
**en ce que** les valeurs d'échantillonnage des signaux (S) à représenter sur l'oscilloscope numérique mises en mémoire temporairement depuis l'identification d'un premier événement de déclenchement sont retardées respectivement les unes par rapport aux autres d'un nombre différent de cycles d'échantillonnage (Tᵢ) et, pour l'analyse fine de la condition de déclenchement, sont transférées sur une mémoire tampon FIFO (first-in-first-out) (41), dans laquelle elles sont mises en mémoire temporairement.

2. Procédé de déclenchement numérique selon la revendication 1,
**caractérisé en ce que**
l'événement de déclenchement est un dépassement ou une non-atteinte d'une parmi plusieurs valeurs seuils (SWᵢ, SWⱼ) par un parmi plusieurs signaux de référence (Sᵢ, Sⱼ), lequel est sélectionné parmi les signaux (S) échantillonnés à enregistrer sur l'oscilloscope numérique.

3. Procédé de déclenchement numérique selon la revendication 2,
**caractérisé en ce que**
le dépassement de la valeur seuil temporelle (SWₜ) par l'intervalle de temps (Δt) entre les deux événements de déclenchement est identifié clairement lorsque le nombre (n) des moments d'échantillonnage déterminés dépasse une première valeur limite supérieure (GW_{O1}).

4. Procédé de déclenchement numérique selon la revendication 2 ou 3,
**caractérisé en ce que**
le dépassement de la valeur seuil temporelle (SWₜ) par l'intervalle de temps (Δt) entre les deux événements de déclenchement n'est pas identifié clairement lorsque le nombre (n) des moments d'échantillonnage déterminés ne dépasse pas une première valeur limite inférieure (GW_{U1}).

5. Procédé de déclenchement numérique selon les revendications 2 à 4,
**caractérisé en ce que**
la non-atteinte de la valeur seuil temporelle (SWₜ) par l'intervalle de temps (Δt) entre les deux événements de déclenchement est identifiée clairement lorsque le nombre (n) des moments d'échantillonnage déterminés n'atteint pas une deuxième valeur limite inférieure (GW_{U2}).

6. Procédé de déclenchement numérique selon l'une quelconque des revendications 2 à 5,
**caractérisé en ce que**
la non-atteinte de la valeur seuil temporelle (SWₜ) par l'intervalle de temps (Δt) entre les deux événements de déclenchement n'est pas identifiée clairement lorsque le nombre (n) des moments d'échantillonnage déterminés dépasse une deuxième valeur limite supérieure (GW_{O2}).

7. Procédé de déclenchement numérique selon la revendication 3 ou 5,
**caractérisé en ce que**,
dans le cas d'une identification claire du dépassement ou de la non-atteinte de la valeur seuil temporelle (SWₜ) par l'intervalle de temps (Δt) entre les deux événements de déclenchement, l'enregistrement d'un ou de plusieurs signaux (S) sur l'oscilloscope numérique est démarré.

8. Procédé de déclenchement numérique selon la revendication 3 ou 4,
**caractérisé en ce que**
le dépassement de la valeur seuil (SWₜ) par l'intervalle de temps (Δt) entre les deux événements de déclenchement n'est ni identifié clairement ni non identifié clairement lorsque le nombre (n) des moments d'échantillonnage déterminés se situe entre les premières valeurs limites inférieure et supérieure (GW_{U1}, GW_{O1}).

9. Procédé de déclenchement numérique selon la revendication 5 ou 6,
**caractérisé en ce que**
la non-atteinte de la valeur seuil (SWₜ) par l'intervalle de temps (Δt) entre les deux événements de déclenchement n'est ni identifiée clairement ni non identifiée clairement lorsque le nombre (n) des moments d'échantillonnage déterminés se situe entre les deuxièmes valeurs limites inférieure et supérieure (GW_{U2}, GW_{O2}).

10. Procédé de déclenchement numérique selon l'une quelconque des revendications 1 à 9,
**caractérisé en ce que**
parmi les différentes valeurs d'échantillonnage mises en mémoire temporairement des signaux (S) échantillonnés à enregistrer sur l'oscilloscope numérique, les valeurs d'échantillonnage (Sᵢₙ, Sᵢₙ₊₁, Sᵢₘ, Sᵢₘ₊₁, Sⱼₘ, Sⱼₘ₊₁), proches de la valeur seuil et mises en mémoire temporairement, des premiers et deuxièmes signaux de référence (Sᵢ, Sⱼ) sélectionnés, sont soumises à une analyse fine subséquente.

11. Procédé de déclenchement numérique selon la revendication 10,
**caractérisé en ce que**
les niveaux de plusieurs premiers points intermédiaires (Z₁) sont déterminés au cours de l'analyse fine entre le dernier moment d'échantillonnage (in) précédant le premier événement de déclenchement et le prochain moment d'échantillonnage (in+1) suivant le premier événement de déclenchement, du premier signal de référence (Sᵢ) sélectionné, au moyen d'une interpolation à intervalles de temps équidistants.

12. Procédé de déclenchement numérique selon la revendication 10 ou 11,
**caractérisé en ce que**
les niveaux de plusieurs deuxièmes points intermédiaires (Z₂) sont déterminés au cours de l'analyse fine entre le dernier moment d'échantillonnage (im, jm) précédant le deuxième événement de déclenchement et le prochain moment d'échantillonnage (im+1, jm+1) suivant le deuxième événement de déclenchement, du premier ou du deuxième signal de référence (Sᵢ, Sⱼ) sélectionné, au moyen d'une interpolation à intervalles de temps équidistants.

13. Procédé de déclenchement numérique selon la revendication 12,
**caractérisé en ce que**,
au moyen d'une comparaison des niveaux des premiers ou deuxièmes points intermédiaires (Z₁, Z₂) à respectivement une valeur seuil (SWᵢ, SWⱼ), à la recherche d'un dépassement ou d'une non-atteinte, le premier ou le deuxième point intermédiaire (Z₁, Z₂) qui présente l'écart de niveau le plus court par rapport à la valeur seuil (SWᵢ, SWⱼ) associée est identifié comme premier ou deuxième événement de déclenchement.

14. Procédé de déclenchement numérique selon la revendication 13,
**caractérisé en ce que**
l'intervalle de temps (Δt) entre le premier et le deuxième événement de déclenchement est comparé à la valeur seuil temporelle (SWₜ), à la recherche d'un dépassement ou d'une non-atteinte.

15. Procédé de déclenchement numérique selon la revendication 14,
**caractérisé en ce que**,
en fonction d'un dépassement ou d'une non-atteinte de la valeur seuil temporelle (SWₜ) par l'intervalle de temps (Δt) entre le premier et le deuxième événement de déclenchement, l'enregistrement des valeurs d'échantillonnage mises en mémoire temporairement des signaux (S) échantillonnés à enregistrer sur l'oscilloscope numérique est démarré sur l'oscilloscope numérique.

16. Système de déclenchement numérique d'un enregistrement d'un ou de plusieurs signaux (S) échantillonnés sur un oscillateur numérique, comprenant un déclenchement numérique dans le cas d'un dépassement ou d'une non-atteinte d'une valeur seuil temporelle (SWₜ) par l'intervalle de temps (Δt) entre deux événements de déclenchement survenus, comprenant au moins un comparateur (5, 10) pour la comparaison d'au moins un signal de référence (Sᵢ, Sⱼ) sélectionné à partir des signaux (S) échantillonnés à enregistrer sur l'oscilloscope numérique à au moins une valeur seuil (SWᵢ, SWⱼ), à la recherche d'un dépassement ou d'une non-atteinte, et une unité (54) qui suit le comparateur (5, 10) et qui est destinée à identifier les conditions de déclenchement,
**caractérisé en ce que**,
en l'absence d'identification claire ou en l'absence de non-identification claire d'une condition de déclenchement par l'unité (54) d'identification de conditions de déclenchement, une identification claire définitive ou une non-identification claire définitive d'une condition de déclenchement est mise en oeuvre par une unité (55) d'identification fine de conditions de déclenchement, et
**en ce que** les valeurs d'échantillonnage des signaux (S) à représenter sur l'oscilloscope numérique mises en mémoire temporairement depuis l'identification d'un premier événement de déclenchement sont retardées les unes par rapport aux autres respectivement d'un nombre différent de cycles d'échantillonnage (Tᵢ) et transférées, pour l'analyse fine de la condition de déclenchement, sur une mémoire tampon FIFO (41) dans laquelle elles sont mises en mémoire temporairement.

17. Système de déclenchement numérique selon la revendication 16,
**caractérisé en ce que**,
pour la détermination du premier événement de déclenchement, un premier signal de référence (Si) est comparé dans un premier comparateur (5) à une valeur seuil (SWᵢ) et, pour la détermination du deuxième événement de déclenchement, un premier ou un deuxième signal de référence (Sᵢ, Sⱼ) est comparé dans un deuxième comparateur (10) à l'une des valeurs seuils (SWᵢ, SWⱼ) dans chaque cas à la recherche d'un dépassement ou d'une non-atteinte.

18. Système de déclenchement numérique selon la revendication 16 ou 17,
**caractérisé en ce que**,
pour la détermination de l'intervalle de temps (Δt) entre le premier et le deuxième événement de déclenchement, les nombres (n) des moments d'échantillonnage des signaux (S) échantillonnés à enregistrer entre le premier et le deuxième événement de déclenchement sont comptés dans un compteur (17).

19. Système de déclenchement numérique selon la revendication 18,
**caractérisé en ce que**
le dépassement ou la non-atteinte de la valeur seuil temporelle (SWₜ) par l'intervalle de temps (Δt) entre le premier et le deuxième événement de déclenchement est obtenu(e) par comparaison des moments d'échantillonnage (n), contenus dans l'intervalle de temps (Δt) desdits événements, des signaux (S) échantillonnés à enregistrer à des valeurs limites supérieure et inférieure (GW_{O1}, GW_{O2}, GW_{U1}, GW_{U2}) dans l'unité (54) d'identification de conditions de déclenchement.

20. Système de déclenchement numérique selon l'une quelconque des revendications 16 à 19,
**caractérisé en ce que**
l'unité (54) d'identification de conditions de déclenchement réalise une identification claire, une non-identification claire ou ni une identification claire ni une non-identification claire du dépassement ou de la non-atteinte de la valeur seuil temporelle (SWₜ) par l'intervalle de temps (Δt) entre le premier et le deuxième événement de déclenchement.

21. Système de déclenchement numérique selon la revendication 20,
**caractérisé en ce que**
les valeurs d'échantillonnage des signaux (S) échantillonnés à enregistrer sur l'oscilloscope numérique sont mises en mémoire temporairement dans la mémoire tampon FIFO (41), au cas où un dépassement ou une non-atteinte de la valeur seuil temporelle (SWₜ) par l'intervalle de temps (Δt) entre le premier et le deuxième événement de déclenchement ne serait ni identifié clairement ni non identifié clairement par l'unité (54) d'identification des conditions de déclenchement.

22. Oscilloscope numérique constitué d'un préamplificateur (1) pour l'adaptation de niveau d'au moins un signal (S) à enregistrer sur l'oscilloscope numérique, d'un convertisseur analogique-numérique (2) pour la conversion analogique-numérique des signaux (S) à enregistrer, d'un système de déclenchement numérique (3) selon l'une quelconque des revendications 16 à 21 et d'une unité d'enregistrement (4) pour la représentation des signaux (S) échantillonnés à enregistrer.
